# DEMANDE DE BREVET EUROPEEN

(11) **EP 4 391 756 A1**
(43) Date de publication de la demande: **26.06.2024**
(21) Numéro de dépôt: 23215706.5
(22) Date de dépôt: 12.12.2023
(51) Int. Cl.: H05K 7/20

(54) **DISPOSITIF ÉLECTRONIQUE DE PUISSANCE**

(30) Priorité: 20.12.2022 FR 2214022
(71) Demandeur: VALEO EQUIPEMENTS ELECTRIQUES MOTEUR, 94046 Créteil Cedex (FR)
(72) Inventeur: FALGUIER, Manuel, 94046 Créteil Cedex (FR); SANCHES, Michael, 94046 Créteil Cedex (FR); GONCALVES-DA-COSTA, Ricardo, 94046 Créteil Cedex (FR)
(74) Mandataire: Valeo Powertrain Systems

(57) **Abrégé**

L'invention concerne un dispositif électronique de puissance (2), notamment pour véhicule. Ledit dispositif (2) comporte :
- un substrat (4), notamment une carte de circuit imprimée, ledit substrat (4) portant :
o au moins un interrupteur commandable (6) ; et
o au moins un composant capacitif (8).

Ledit dispositif (2) comporte en outre :
- au moins un canal de circulation d'un liquide de refroidissement (10). Lorsque ledit dispositif (2) est observé suivant un axe (A) perpendiculaire au substrat (4), le canal de circulation (10) s'étend, au moins sur un tronçon dudit canal (10), en regard à la fois de l'interrupteur commandable (6) et du composant capacitif (8) de sorte que le liquide de refroidissement s'écoulant dans ce tronçon puisse refroidir ledit interrupteur commandable (6) et ledit composant capacitif (8).

## Description

La présente invention concerne, de manière générale, un dispositif électronique de puissance, notamment pour véhicule.

L'invention concerne également une machine électrique tournante comportant un tel dispositif électronique de puissance.

On connaît un dispositif électronique de puissance, notamment pour véhicule, tel qu'onduleur ou redresseur, comportant un substrat, notamment une carte de circuit imprimée. Ledit substrat portant des composants de puissance tels que des condensateurs et des transistors, notamment des transistors à effet de champ à structure métal-oxyde-semiconducteur (« Metal Oxide Semiconductor Field Effect Transistor » ou MOSFET selon la terminologie anglaise).

Premièrement, ces composants de puissance peuvent être soumis à des variations de température allant de -40°C à 120°C lorsque ledit dispositif électronique de puissance est intégré dans un véhicule. Ces composants de puissance peuvent être non seulement chauffés par la variation de la température de l'environnement externe au véhicule, mais aussi par effet joule lorsqu'ils sont en fonctionnement. Cette augmentation de température peut endommager lesdits composants lorsque la température de ceux-ci dépasse une valeur limite de température de fonctionnement recommandée par les fabricants.

Par ailleurs, une boucle inductive formée entre les bornes positives et négatives du condensateur et dudit transistor respectifs entraîne des pertes par commutation pour ledit transistor. Ces pertes par commutation participent également à une hausse de température dudit transistor.

L'invention vise à surmonter ces inconvénients et à refroidir efficacement les composants de puissance tout en réduisant des boucles inductives formées par ces composants de puissance.

La présente invention a ainsi pour objet un dispositif électronique de puissance, notamment pour véhicule, ledit dispositif comportant :
- un substrat, notamment une carte de circuit imprimée, ledit substrat portant :
   ∘ au moins un interrupteur commandable ; et
   ∘ au moins un composant capacitif ;
ledit dispositif comportant en outre :
- au moins un canal de circulation d'un liquide de refroidissement ; et
lorsque ledit dispositif est observé suivant un axe perpendiculaire au substrat, le canal de circulation s'étend, au moins sur un tronçon dudit canal, en regard à la fois de l'interrupteur commandable et du composant capacitif de sorte que le liquide de refroidissement s'écoulant dans ce tronçon puisse refroidir ledit interrupteur commandable et ledit composant capacitif.

Grâce à l'invention, le composant capacitif et l'interrupteur commandable sont refroidis de façon efficace par ledit tronçon du canal de circulation d'un liquide de refroidissement formant un dissipateur de chaleur. En particulier, le liquide de refroidissement a une capacité calorifique plus élevée que l'air, ce qui permet d'évacuer plus efficacement la chaleur émise ou reçue par le composant capacitif et l'interrupteur commandable, qu'avec des ailettes classiques. En outre, la distance entre le composant capacitif et l'interrupteur commandable est limitée par la largeur du tronçon dudit canal de sorte que le phénomène de la boucle inductive provoquant la hausse de la température dudit interrupteur commandable soit réduit.

Selon l'un des aspects de l'invention, une pluralité de composants capacitifs sont disposés suivant une première rangée et une pluralité d'interrupteurs commandables sont disposés suivant une deuxième rangée de sorte que lesdites première et deuxième rangées soient sensiblement parallèles entre elles.

Selon l'un des aspects de l'invention, lesdites rangées sont sensiblement parallèles entre elles le long dudit canal de circulation.

Selon l'un des aspects de l'invention, la distance entre lesdites deux rangées est plus petite que la moitié de la dimension maximale dudit interrupteur commandable, de préférence plus petite que la dixième de la dimension maximale dudit interrupteur commandable.

De cette manière, le phénomène de la boucle inductive favorisant la hausse de température des interrupteurs commandables est encore plus réduite.

Selon l'un des aspects de l'invention, le composant capacitif est un condensateur.

Selon l'un des aspects de l'invention, le composant capacitif présente une forme générale cylindrique.

Selon l'un des aspects de l'invention, le substrat porte au moins une embase agencée pour recevoir ledit composant capacitif.

Selon l'un des aspects de l'invention, l'interrupteur commandable est un transistor, par exemple un transistor à effet de champ à structure métal-oxyde-semiconducteur (« Metal Oxide Semiconductor Field Effect Transistor » ou MOSFET selon la terminologie anglaise).

Selon l'un des aspects de l'invention, l'interrupteur commandable a la forme d'une plaque, sensiblement rectangulaire.

Selon l'un des aspects de l'invention, l'interrupteur commandable est encastré dans le substrat selon la profondeur du substrat suivant un axe perpendiculaire au substrat.

Selon l'un des aspects de l'invention, l'épaisseur de l'interrupteur commandable est au maximum l'épaisseur du substrat suivant un axe perpendiculaire au substrat.

Selon l'un des aspects de l'invention, ledit dispositif électronique de puissance comporte au moins un logement muni d'un fond agencé pour recevoir ledit composant capacitif.

Selon l'un des aspects de l'invention, ledit canal de circulation présente dans une section transversale avec une hauteur qui varie suivant un axe perpendiculaire au substrat.

Selon l'un des aspects de l'invention, la section transversale dudit canal de circulation a sensiblement une forme en L.

On peut avoir une forme autre qu'une forme en L pour la section transversale du canal, pourvu que cette forme permette de refroidir efficacement ledit interrupteur commandable et ledit composant capacitif.

Selon l'un des aspects de l'invention, le canal de circulation présente une section transversale en forme en L avec une branche verticale faisant face à un côté du logement dudit composant capacitif et une autre branche horizontale qui passe sous ledit logement.

Selon l'un des aspects de l'invention, la branche verticale dudit canal en L vient en regard dudit interrupteur commandable et la branche horizontale dudit canal en L vient en regard dudit composant capacitif.

De cette manière, les chaleurs émises ou reçues par le composant capacitif et l'interrupteur commandable sont évacuées de manière efficace par le canal de circulation.

Selon l'un des aspects de l'invention, le composant capacitif comporte un sommet et une base, la base étant la face dudit composant capacitif en contact avec ledit substrat et le sommet étant la face dudit composant capacitif opposée de la base.

Selon l'un des aspects de l'invention, ledit dispositif comporte une pâte thermique entre le sommet du composant capacitif et le fond dudit logement.

La pâte thermique favorise une bonne conduction thermique entre le composant capacitif et ledit canal.

Selon l'un des aspects de l'invention, ledit canal de circulation comporte au moins une entrée et une sortie de liquide de refroidissement chacune agencée pour être connectée à un dispositif d'échange de chaleur.

Selon l'un des aspects de l'invention, l'entrée et la sortie dudit canal ont une forme sensiblement circulaire.

Selon l'un des aspects de l'invention, ledit dispositif comporte un couvercle agencé à coopérer avec ledit canal de circulation.

Selon l'un des aspects de l'invention, ledit canal de circulation comporte au moins une marche destinée à recevoir ledit couvercle.

Selon l'un des aspects de l'invention, les marches sont situées de chaque côté suivant la largeur du canal de circulation.

Selon l'un des aspects de l'invention, ledit dispositif comporte un joint d'étanchéité entre ledit couvercle et ledit canal de circulation.

Selon l'un des aspects de l'invention, ledit dispositif électronique de puissance comporte :
- une première face portant ledit substrat ; et
- une deuxième face portant ledit canal de circulation.

Selon l'un des aspects de l'invention, l'interrupteur commandable et le composant capacitif sont orientés vers le côté dudit canal de circulation, à savoir vers ladite deuxième face, de sorte à évacuer de la chaleur vers ledit canal de circulation.

Selon l'un des aspects de l'invention, ledit canal de circulation est formé sur une partie surélevée par rapport à un socle situé sur la deuxième face dudit dispositif électronique de puissance.

Selon l'un des aspects de l'invention, la première face dudit dispositif électronique de puissance comporte un renfoncement agencé pour fixer ledit substrat.

Selon l'un des aspects de l'invention, ledit liquide de refroidissement qui circule dans ledit canal de circulation peut être un réfrigérant liquide de l'eau, incluant éventuellement des additifs, ou de l'eau glycolée.

Selon l'un des aspects de l'invention, ledit canal de circulation a une forme générale d'un arc de cercle ayant un angle compris entre 270 et 350°, de préférence entre 300 et 330°.

Selon l'un des aspects de l'invention, ledit canal de circulation a un pourtour externe ayant une forme sensiblement en oméga lorsqu'il est observé du côté de la deuxième face selon un axe perpendiculaire au substrat.

Selon l'un des aspects de l'invention, le dispositif électronique de puissance est un onduleur ou un redresseur de tension.

L'invention a encore pour objet une machine électrique tournante, notamment pour véhicule, la machine électrique tournante comportant :
- une source d'alimentation, notamment en tension continue ou en tension alternative ; et
- le dispositif électronique de puissance selon l'invention destiné à être connecté à la source d'alimentation.

D'autres caractéristiques, détails et avantages de l'invention ressortiront plus clairement à la lecture de la description détaillée donnée ci-après, et de plusieurs exemples de réalisation donnés à titre indicatif et non limitatif en référence aux dessins schématiques annexés d'autre part, sur lesquels :
[Fig.1] représente schématiquement et partiellement, une vue de coupe transversale d'un dispositif électronique de puissance selon l'invention,
[Fig.2] représente schématiquement et partiellement, en perspective, une vue de coupe transversale du dispositif électronique de puissance sans le couvercle d'un canal de circulation,
[Fig.3] représente schématiquement et partiellement, une vue en perspective du dispositif électronique de puissance avec le couvercle du canal de circulation,
[Fig.4] représente schématiquement et partiellement, une vue de dessus d'une portion du substrat.

Les modes de réalisation qui sont décrits dans la suite ne sont nullement limitatifs ; on pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. En particulier, toutes les variantes et tous les modes de réalisation décrits sont combinables entre eux si rien ne s'oppose à cette combinaison sur le plan technique.

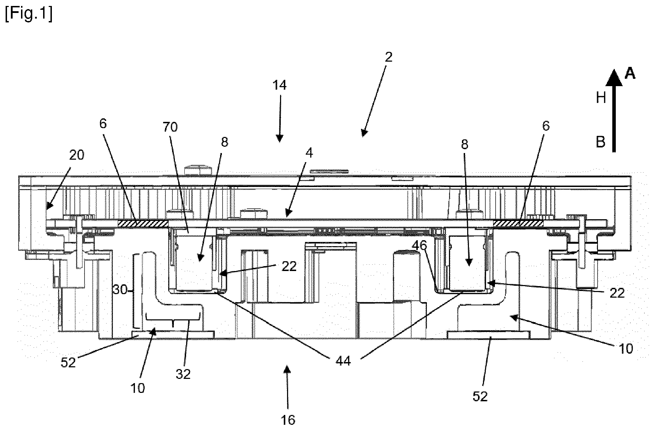

La figure 1 représente un dispositif électronique de puissance 2, notamment pour véhicule (non-représenté). Le dispositif électronique de puissance 2 est un onduleur ou un redresseur de tension.

Ledit dispositif 2 comporte :
- une carte de circuit imprimée 4 portant :
   ∘ une pluralité de transistors à effet de champ à structure métal-oxyde-semiconducteur (« Metal Oxide Semiconductor Field Effect Transistor » ou MOSFET selon la terminologie anglaise) 6 ayant la forme d'une plaque, sensiblement rectangulaire ; et
   ∘ une pluralité de condensateurs 8 présentant une forme générale cylindrique.

Ledit dispositif 2 comporte en outre :
- un canal de circulation d'un liquide de refroidissement 10,

On définit un axe perpendiculaire à carte de circuit imprimée 4, dénommé ci-après un axe A. Dans ce qui suit, la hauteur sera évaluée selon ledit axe A. Le terme « haut » sera compris comme étant situé du côté de la carte de circuit imprimée 4 suivant ledit axe A. Le terme « bas » sera compris comme étant situé du côté du canal de circulation 10 suivant ledit axe A.

On définit un plan définissant l'une des faces de la carte de circuit imprimée 4, dénommé ci-après un plan P.

On entend par « vertical » ce qui est perpendiculaire à ce plan P et par « horizontal » ce qui est parallèle à ce plan.

Lorsque ledit dispositif 2 est observé suivant ledit axe A, le canal de circulation 10 s'étend en regard à la fois des transistors MOSFET 6 et des condensateurs 8 de sorte que le liquide de refroidissement s'écoulant dans ce canal de circulation 10 puisse refroidir lesdits transistors MOSFET 6 et lesdits condensateurs 8.

Grâce à l'invention, les condensateurs 8 et les transistors MOSFET 6 sont refroidis de façon efficace par ledit canal de circulation d'un liquide de refroidissement 10 formant un dissipateur de chaleur. En particulier, le liquide de refroidissement a une capacité calorifique plus élevée que l'air, ce qui permet d'évacuer plus efficacement la chaleur émise ou reçue par les condensateurs 8 et les transistors MOSFET 6, qu'avec des ailettes classiques. En outre, la distance d entre les condensateurs 8 et les transistors MOSFET 6 est limitée par la largeur du canal de circulation 10 de sorte que le phénomène de la boucle inductive provoquant la hausse de la température desdits transistors MOSFET 6 soit réduit.

Toujours dans l'exemple de la figure 1, le dispositif électronique de puissance 2 comporte en outre :
- une première face 14 portant ladite carte de circuit imprimée 4 ; et
- une deuxième face 16 portant ledit canal de circulation 10.

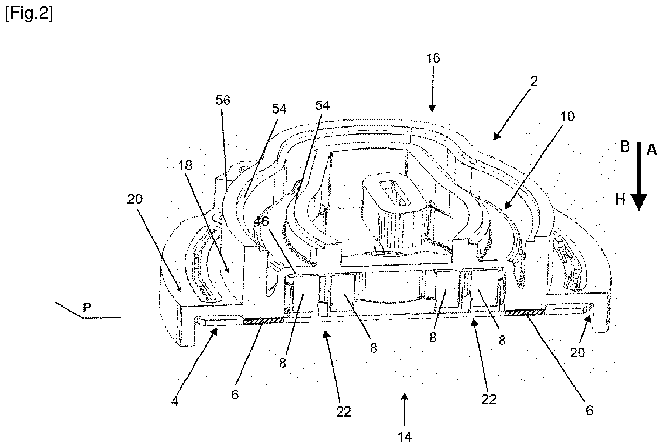

Comme illustré sur les figures 1 et 2, la première face 14 dudit dispositif électronique de puissance 2 comporte un renfoncement 20 agencé pour fixer ladite carte de circuit imprimée 4.

Toujours dans l'exemple des figures 1 et 2, les transistors MOSFET 6 et les condensateurs 8 sont orientés vers le côté dudit canal de circulation 10, à savoir vers ladite deuxième face 16, de sorte à évacuer de la chaleur vers ledit canal de circulation 10.

Comme on voit sur la figure 2, ledit canal de circulation 10 est formé sur une partie surélevée 18 par rapport à un socle 20 situé sur la deuxième face 16 dudit dispositif électronique de puissance 2.

Comme illustré sur les figures 1 et 2, les transistors MOSFETS 6 sont encastrés dans la carte de circuit imprimée 4 selon la profondeur de la carte de circuit imprimée 4, suivant ledit axe A.

L'épaisseur des transistors MOSFET 6 est au maximum l'épaisseur de la carte de circuit imprimée 4 suivant ledit axe A.

Ledit dispositif 2 comporte une pluralité de logements 22 agencés pour recevoir les condensateurs 8.

Ledit canal de circulation 10 présente une section transversale ayant une forme en L avec une branche verticale 30 faisant face à un côté des logements 22 des condensateurs 8 et une autre branche horizontale 32 qui passe sous lesdits logements 22.

La branche verticale 30 dudit canal 10 en L vient en regard des transistors MOSFET 6 et la branche horizontale 32 dudit canal 10 en L vient en regard des condensateurs 8.

De cette manière, les chaleurs émises ou reçues par les condensateurs 8 et les transistors MOSFET 6 sont évacuées de manière efficace par le canal de circulation 10 en L.

Chaque condensateur 8 comporte un sommet 40 et une base 42, la base 42 étant la face du condensateur 8 en contact avec la carte de circuit imprimée 4 et le sommet 40 étant la face du condensateur 8 opposée de la base 42.

Comme illustré sur les figures 1 et 2, ledit dispositif 2 comporte une pâte thermique 44 entre les sommets 40 desdits condensateurs 8 et le fond 46 de chaque logement 22.

La pâte thermique 44 favorise une bonne conduction thermique entre les condensateurs 8 et ledit canal 10.

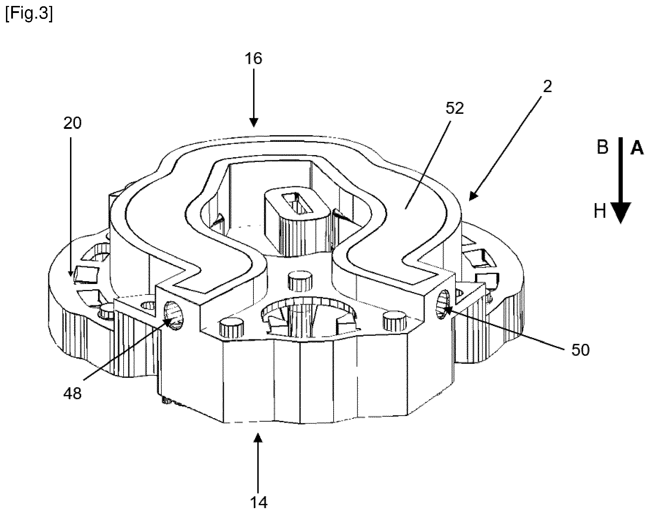

En se référant à la figure 3, on voit que ledit canal de circulation 10 comporte une entrée et une sortie de liquide de refroidissement 48, 50 chacune agencée pour être connectée à un dispositif d'échange de chaleur (non-représenté). L'entrée et la sortie dudit canal 48, 50 ont une forme sensiblement circulaire.

Comme illustré sur les figures 1 et 3, ledit dispositif 2 comporte un couvercle 52 agencé à coopérer avec ledit canal de circulation 10 comportant des marches 54 destinée à recevoir ledit couvercle 52. Les marches 54 sont situées de chaque côté suivant la largeur du canal de circulation 10.

Ledit dispositif 2 comporte en outre un joint d'étanchéité (non-représenté) entre ledit couvercle 52 et ledit canal de circulation 10.

Comme on voit sur la figure 3, ledit canal de circulation 10 a un pourtour externe 56 ayant une forme sensiblement en oméga lorsqu'il est observé du côté de la deuxième face 16 selon ledit axe A.

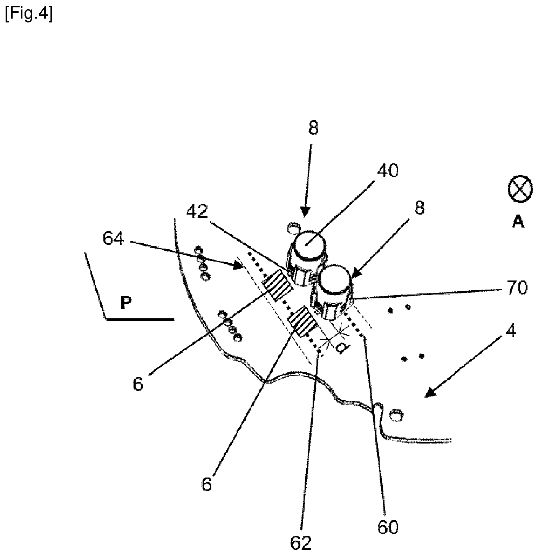

Comme illustré sur la figure 4, deux condensateurs 8 sont disposés suivant une première rangée 60 et deux transistors MOSFET 6 sont disposés suivant une deuxième rangée 62 de sorte que lesdites première et deuxième rangées 60, 62 soient sensiblement parallèles entre elles.

Ces deux condensateurs 8 et ces deux transistors MOSFET 6 sont disposés sur un tronçon 64 dudit canal de circulation 10.

Lesdites rangées 60, 62 sont sensiblement parallèles entre elles le long dudit canal de circulation 10.

La distance d entre lesdites deux rangées 60, 62 est plus petite que la moitié de la dimension maximale des transistors MOSFET 6.

De cette manière, le phénomène de la boucle inductive favorisant la hausse de température des transistors MOSFET 6 est encore plus réduite.

Une pluralité de condensateurs 8 et de transistors 6 sont donc disposés le long dudit canal 10 tout en restant sensiblement parallèles et en gardant une distance d entre eux.

La carte de circuit imprimée 4 porte une pluralité d'embases 70 agencées pour recevoir chaque condensateur 8.

Ledit liquide de refroidissement qui circule dans ledit canal de circulation 10 peut être un réfrigérant liquide de l'eau, incluant éventuellement des additifs, ou de l'eau glycolée. 1

## Revendications

1. Dispositif électronique de puissance (2), notamment pour véhicule, ledit dispositif (2) comportant :
- un substrat (4), notamment une carte de circuit imprimée, ledit substrat (4) portant :
o au moins un interrupteur commandable (6) ; et
o au moins un composant capacitif (8) ;
ledit dispositif (2) étant **caractérisé en ce qu'**il comporte en outre :
- au moins un canal de circulation d'un liquide de refroidissement (10) ; et
lorsque ledit dispositif (2) est observé suivant un axe (A) perpendiculaire au substrat (4), le canal de circulation (10) s'étend, au moins sur un tronçon (64) dudit canal (10), en regard à la fois de l'interrupteur commandable (6) et du composant capacitif (8) de sorte que le liquide de refroidissement s'écoulant dans ce tronçon (64) puisse refroidir ledit interrupteur commandable (6) et ledit composant capacitif (8).

2. Dispositif (2) selon la revendication 1, dans lequel une pluralité de composants capacitifs (8) sont disposés suivant une première rangée (60) et une pluralité d'interrupteurs commandables (6) sont disposés suivant une deuxième rangée (62) de sorte que lesdites première et deuxième rangées (60, 62) soient sensiblement parallèles entre elles.

3. Dispositif (2) selon la revendication 2, dans lequel lesdites rangées (60, 62) sont sensiblement parallèles entre elles le long dudit canal de circulation (10).

4. Dispositif (2) selon la revendication 2 ou 3, dans lequel la distance (d) entre lesdites deux rangées (60, 62) est plus petite que la moitié de la dimension maximale dudit interrupteur commandable (6), de préférence plus petite que la dixième de la dimension maximale dudit interrupteur commandable (6).

5. Dispositif (2) selon l'une quelconque des revendications précédentes, dans lequel ledit dispositif électronique de puissance (2) comporte au moins un logement (22) muni d'un fond (46) agencé pour recevoir ledit composant capacitif (8).

6. Dispositif (2) selon l'une quelconque des revendications précédentes, dans lequel ledit canal de circulation (10) présente une section transversale avec une hauteur qui varie suivant un axe (A) perpendiculaire au substrat.

7. Dispositif (2) selon la revendication 6, dans lequel le canal de circulation (10) présente une section transversale en forme en L avec une branche verticale (30) faisant face à un côté du logement (22) dudit composant capacitif (8) et une autre branche horizontale (32) qui passe sous ledit logement (22).

8. Dispositif (2) selon la revendication 7, dans lequel la branche verticale (30) dudit canal (10) en L vient en regard dudit interrupteur commandable (6) et la branche horizontale (32) dudit canal (10) en L vient en regard dudit composant capacitif (8).

9. Machine électrique tournante, notamment pour véhicule, la machine électrique tournante comportant :
- une source d'alimentation, notamment en tension continue ou en tension alternative ; et
- le dispositif électronique de puissance (2) selon l'une des revendications 1 à 8, destiné à être connecté à la source d'alimentation.
